# EUROPEAN PATENT APPLICATION

(11) **EP 1 385 171 A2**
(43) Date of publication of application: **28.01.2004**
(21) Application number: 03016351.3
(22) Date of filing: 18.07.2003
(51) Int. Cl.: G11C 11/14

(54) **Method for recording in a nonvolatile solid-state magnetic memory**

(30) Priority: 22.07.2002 JP 2002212003
(71) Applicant: Tohoku University, Sendai City, Miyagi Pref. (JP)
(72) Inventor: Ohno, Hideo, Sendai City, Miyagi Pref. (JP); Matsukura, Fumihiro, Sendai City, Miyagi Pref. (JP); Chiba, Daichi, Sendai City, Miyagi Pref. (JP)
(74) Representative: von Hellfeld, Axel, Dr. Dipl.-Phys.

(57) **Abstract**

On a given substrate are successively formed a buffer layer, a recording layer made of carrier induced ferromagnetic material, a metallic electrode layer via an insulating layer, to complete a nonvolatile solid-state magnetic memory as an electric field effect transistor. For recording, a first electric field is applied to the recording layer via the metallic electrode layer under a given external magnetic field, and then, a second electric field is applied to the recording layer via the metallic electrode layer so that the hole carrier concentration of the recording layer can be reduced lower than at the application of the first electric field, thereby to invert the magnetization of the recording layer and thus, realize recording operation for the recording layer.

## Description

### BACKGROUND OF THE INVENTION

### Field of the Invention

This invention relates to a method for recording in a nonvolatile solid-state magnetic memory.

### Description of the prior art

With a nonvolatile solid-state magnetic memory having a ferromagnetic layer as a recording layer, it is required for recording to apply a given external magnetic field to the recording layer. On the other hand, it is desired to develop the integration density of the nonvolatile solid-state magnetic memory, and in this point of view, the miniaturization for constituents of the nonvolatile solid-state magnetic memory such as the recording layer is desired.

The miniaturization causes the enhancement of the demagnetizing field in the recording layer, so that conventionally, it is required for recording in the nonvolatile solid-state magnetic memory to apply to the memory an external magnetic field large enough to invert the magnetization of the recording layer against the large demagnetizing field thereof. As a result, in recording, a large electric power consumption is required, and thus, the nonvolatile solid-state magnetic memory practically usable and of low electric power consumption was able to be provided.

### SUMMERY OF THE INVENTION

It is an object of the present invention, in order to provide a nonvolatile solid-state magnetic memory practically usable and of low electric power consumption, to realize a new recording method for the memory.

For achieving the above object, this invention relates to a method for recording in a nonvolatile solid-state magnetic field with a recording layer made of carrier induced ferromagnetic material, comprising the steps of:
applying a given magnetic field to the recording layer
applying a first electric field to the recording layer under the magnetic field, and
applying a second electric field to the recording layer under the magnetic field so that a hole carrier concentration of the recording layer is reduced lower than at the application of the first electric field, to invert a magnetization of the recording layer and thus, realize recording operation for the recording layer.

The carrier induced ferromagnetic material is one of new ferromagnetic semiconductors, and can control the magnetic property thereof by adjusting the carrier number and the carrier spin polarization by means of light or electric field. The inventors have conceived to utilize the carrier induced ferromagnetic material as a recording layer of a nonvolatile solid-state magnetic memory. In this case, by applying to the recording layer a first electric field and a second electric field satisfying the above-mentioned requirement under a given magnetic field, the magnetization of the recording layer can be inverted. In other words, the magnetization of the recording layer can be inverted by switching to the second electric field from the first electric field.

As a result, according to the present invention, the recording performance for a nonvolatile solid-state magnetic memory can be done, so that the nonvolatile solid-state magnetic memory practically usable and of low electric power consumption can be provided.

When the first electric field and the second electric field are applied to the recording layer alternately and successively, the magnitude of the magnetization of the recording layer can be increased and decreased to be inverted alternately and successively. Therefore, if information is stored in the recording layer of the nonvolatile solid-state magnetic memory on the direction of the magnetization of the recording layer, the recording performance for the nonvolatile solid-state magnetic memory can be done successively.

In a preferred embodiment of the present invention, the recording layer is formed above a substrate, and a metallic electrode layer is formed above the recording layer via an insulating layer, thereby to complete an electric field effect transistor. In this case, the recording layer functions as a channel layer, and the metallic electrode layer functions as a gate electrode. Therefore, the electric field for the reduction of the coercive force of the recording layer can be applied to the nonvolatile solid-state magnetic memory via the metallic electrode layer, and then, the recording operation for the nonvolatile solid-state magnetic memory can be simplified.

Other advantages and details of the present invention will be described below.

### BRIEF DESCRIPTION OF THE DRAWINGS

For better understanding of the present invention, reference is made to the attached drawings, wherein
Fig. 1 is a structural view showing a nonvolatile solid-state magnetic memory to be recorded according to the present invention,
Fig. 2 is an explanatory view showing the principle of the recording method of the present invention,
   and
Fig. 3 is a graph showing the variation in hall resistance of the recording layer of the nonvolatile solid-state magnetic memory when the recording operation of the present invention is carried out.

### DESCRIPTION OF THE PREFERRED EMBODIMENTS

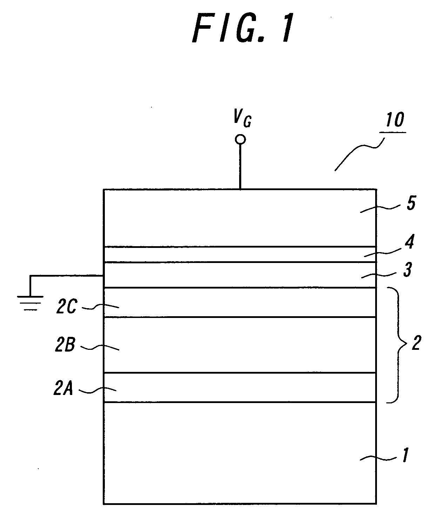

Fig. 1 is a structural view showing a nonvolatile solid-state magnetic memory to be recorded according to the present invention. In the nonvolatile solid-state magnetic memory 10 illustrated in Fig. 1, on a given substrate 1 are formed successively a buffer layer 2, a recording layer 3 made of carrier induced ferromagnetic material, and a metallic electrode layer 5 via an insulating layer 4, thereby to complete an electric field effect transistor.

It is desired that the carrier induced ferromagnetic material forming the recording layer 3 is ferromagnetic semiconductor such as (Ga, Mn)As or (In, Mn)As, which has excellent ferromagnetic semiconductor properties and whereby the recording operation for the nonvolatile solid-state magnetic memory according to the present invention can be performed in good condition and the recording information can be retained stably for a long time.

The thickness of the recording layer 3 is preferably set within 0.3-200nm, particularly within 3-10nm. In this case, the nonvolatile solid-state magnetic memory can be sufficiently miniaturized under the recording performance in good condition and the stable retention of the recording information.

In the case that the recording layer 3 is made of the carrier induced ferromagnetic semiconductor as mentioned above, the substrate 1 is preferably made of GaAs single crystal. In this case, the recording layer 3 can be epitaxially grown in good crystallinity, to enhance the performance of the nonvolatile solid-state magnetic memory 10.

In Fig. 1, the buffer layer 3 is constructed of a multilayered structure composed of semiconductor layers 2A-2C. In this case, the difference in lattice constant between the substrate 1 and the recording layer 3 can be compensated effectively, to enhance the epitaxial growth of the recording layer 3 and thus, develop the performance of the nonvolatile solid-state magnetic memory 10 effectively and efficiently.

The multilayered buffer layer can be preferably employed when the recording layer 3 is made of (In, Mn)As and the substrate 1 is made of (001)GaAs single crystal. Since the mismatch in lattice constant between the (In, Mn)As and the (001)GaAs single crystal is about 7%, the use of the multilayered buffer layer can compensate the mismatch in lattice constant and thus, prompt the eptitaxial growth of the recording layer 3. In this case, the semiconductor layer 2A is made of AlSb layer, and the semiconductor layer 2b is made of AlGaSb layer, and the semiconductor layer 2c is made of InAs layer.

The insulating layer 4 may be made of an inorganic material such as SiO₂, SiN, Al₂O₃ or an organic material such as polyimide. The metallic electrode layer 5 may be made of conductive metallic material such as Al or Au.

Then, a recording method using the nonvolatile solid-state magnetic memory 10 will be described below. Since the nonvolatile solid-state magnetic memory 10 is so constructed as the electric field effect transistor, the metallic electrode layer 5 functions as a gate electrode and the recording layer 3 functions as a channel layer.

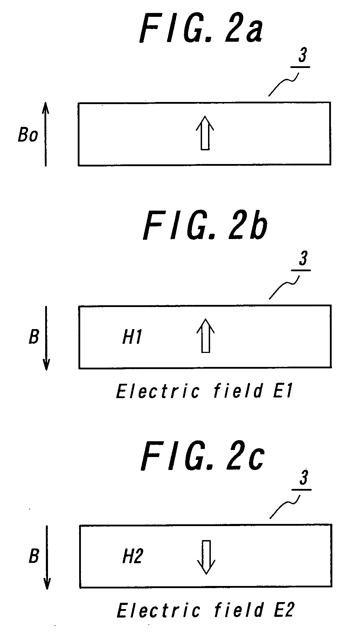

Fig. 2 is an explanatory view showing the principle of the recording method of the present invention. In the figures, the direction of the magnetization of the recording layer 3 is designated by the arrow. First of all, as shown in Fig. 2(a), a given external magnetic field B₀ is applied to the recording layer 3 of the nonvolatile solid-state magnetic memory 10, to be initialized, e.g., by upward alignment of the magnetization while a given electric field is applied to the recording layer 3 so as to reduce the hole carrier concentration of the recording layer 3. In this case, since the coercive force of the recording layer 3 is reduced by the electric field, the magnetization of the recording layer 3 can be inverted by the external magnetic field B₀ with relatively small intensity.

Then, as shown in Fig. 2(b), another external magnetic field is applied to the recording layer 3 in the direction opposite to the magnetic field B₀ under a first electric field E1 for a given period of time. Then, a second electric field E2 is applied to the recording layer 3 so that the hole carrier concentration of the recording layer 3 can be reduced lower than at the time when the first electric field E1 is applied. In this case, as shown in Fig. 2(c), the magnetization of the recording layer 3 is inverted through the switching of the electric field, and thus, the recording operation for the recording layer 3 can be performed.

The application periods of time of the first electric field and the second electric field can be adjusted on the sort and the configuration of the nonvolatile solid-state magnetic memory 10, but preferably set within a range of several ns to several µs.

If the steps shown in Figs. 2(a) and 2(b) are carried out successively, the magnetization of the recording layer 3 can be inverted successively, so that if information is stored in the recording layer 3 on the direction of the magnetization of the recording layer 3, the recording operation can be carried out successively.

If the coercive forces of the recording layer 3 are set to "H1" and "H2" at the application of the first electric field E1 and the second electric field E2, respectively, the relation of "H1>H2" is satisfied because the hole carrier concentration of the recording layer 3 is decreased by the second electric field E2. Therefore, the recording operation for the recording layer 3 can be performed in good condition only if the magnetic field B is applied so as to satisfy the relation of "H1>B>H2". However, it is not always required to satisfy the above relation of the intensity of the magnetic field B.

The intensities of the first electric field and the second electric field are not restricted only if the recording operation can be performed on the recording principle as shown in Fig. 2. Preferably, the intensity of the first electric field is set within 0-10MV/cm, and the intensity of the second electric field is set within 0-0.01MV/cm. More preferably, the absolute intensity of the second electric field E2 is set larger than that of the first electric field E1. In this case, the recording operation can be performed in good condition, irrespective of the thickness of the recording layer 3 and the like.

### (Example)

In this Example, a nonvolatile solid-state magnetic memory as shown in Fig. 1 was fabricated. A (001)GaAs single crystal substrate was employed, and heated to 550°C. Then, an AlAs layer and an Al_{0.82}Ga_{0.18}Sb layer were successively formed in thicknesses of 50nm and 300nm, respectively on the substrate by means of MBE. Then, the substrate was cooled down to 450°C, and an InAs layer was formed in a thickness of 5nm by means of MBE, to complete a buffer layer.

Then, the substrate was cooled down to 250°C, and an (In_{0.967}Mn_{0.033})As layer as a recording layer was formed in a thickness of 4nm by means of MBE. Then, an SiO₂ insulating layer was formed in a thickness of 0.9 µm by means of spin coating, and a Cr(5nm)/Au(95nm) as a metallic electrode layer was formed by means of deposition, thereby to complete an intended nonvolatile solid-state magnetic memory.

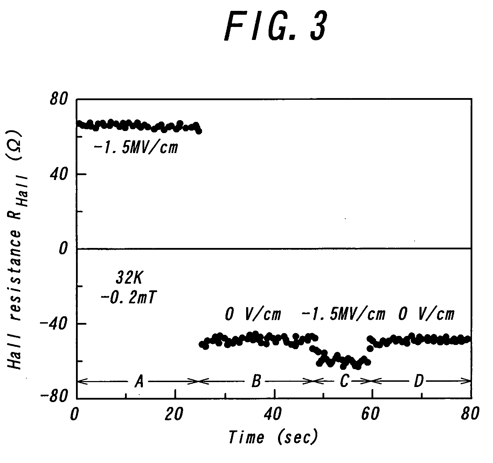

Then, recording operation was performed for the (In_{0.967}Mn_{0.033})As recording layer on the recording principle as shown in Fig. 2. Fig. 3 is a graph showing the variation in Hall resistance R_{Hall} of the recording layer at 32K. In the recording operation, first of all, an electric field of -1.5MV/cm was applied to the (In_{0.967}Mn_{0.033})As recording layer to be initialized via the Cr/Au electrode layer under a magnetic field of 5mT.

Then, an electric field of -1.5MV/cm was applied to the (In_{0.967}Mn_{0.033})As recording layer under a magnetic field of -0.2mT during the period of 0-25 seconds. Then, the electric field was off under the same magnetic field during the period of 25-47 seconds. In this case, the Hall resistance of the (In_{0.967}Mn_{0.033})As recording layer was varied to about -50Ω from about 53Ω. In other words, the magnetization of the (In_{0.967}Mn_{0.033})As recording layer was inverted by the switching of the electric field. Therefore, the recording operation can be performed if information is stored in the (In_{0.967}Mn_{0.033})As recording layer on the direction of the magnetization thereof.

Then, when an electric field of -1.SMV/cm was applied again to the (In_{0.967}Mn_{0.033})As recording layer during the period of 47-60 seconds, the Hall resistance was varied and the magnetization was increased. Then, when the electric field was off again during the period of 60-80 seconds, the Hall resistance was varied and the magnetization was decreased. In this case, therefore, successive recording operation can be performed through the successive switching of the electric field only if information is stored in the (In_{0.967}Mn_{0.033})As recording layer on the direction of the magnetization thereof.

Although the present invention was described in detail with reference to the above examples, this invention is not limited to the above disclosure and every kind of variation and modification may be made without departing from the scope of the present invention.

As mentioned above, according to the present invention, a recording method for a new nonvolatile solid-state magnetic memory practically usable and of low electric consumption can be provided.

## Claims

1. A method for recording in a nonvolatile solid-state magnetic field with a recording layer made of carrier induced ferromagnetic material, comprising the steps of:
applying a given magnetic field to said recording layer
applying a first electric field to said recording layer under said magnetic field,
and
applying a second electric field to said recording layer under said magnetic field so that a hole carrier concentration of said recording layer is reduced lower than at the application of said first electric field, to invert a magnetization of said recording layer and thus, realize recording operation for said recording layer.

2. The recording method as defined in claim 1, wherein said first electric field and said second electric field are applied alternately to said recording layer, to invert said magnetization of said recording layer alternately, and thus, realize successive recording operation for said recording layer.

3. The recording method as defined in claim 1 or 2, wherein an intensity of said magnetic field is set within a coercive force range of said recording layer during the application of said first electric field and said second electric field.

4. he recording method as defined in any one of claims 1-3, wherein said carrier induced ferromagnetic material is carrier induced ferromagnetic semiconductor.

5. The recording method as defined in claim 4, wherein said carrier induced ferromagnetic semiconductor is at least one of (Ga, Mn)As and (In, Mn)As.

6. The recording method as defined in any one of claims 1-5, wherein a thickness of said recording layer is set within 0.3-200nm.

7. The recording method as defined in any one of claims 1-6, wherein an absolute intensity of said first electric field is set within 0-10MV/cm and an absolute intensity of said second electric field is set larger than said absolute intensity of said first electric field.

8. The recording method as defined in any one of claims 1-7, wherein said nonvolatile solid-state magnetic memory includes a given substrate to support said recording layer and a metallic electrode layer provided above said recording layer via an insulating layer, thereby to complete an electric field effect transistor, and said recording layer functions as a channel layer and said metallic electrode layer functions as a gate electrode, whereby said first electric field and said electric field are applied to said recording layer via said metallic electrode layer.

9. The recording method as defined in claim 8, wherein said nonvolatile solid-state magnetic memory includes a buffer layer between said substrate and said recording layer.

10. The recording method as defined in any one of claims 5-9, wherein said substrate is made of GaAs.
